(19) Europäisches Patentamt
European Patent Office
Office européen des brevets

(11) **EP 4 783 463 A1**

(12) **DEMANDE DE BREVET EUROPEEN**

(43) Date de publication:
**29.07.2026 Bulletin 2026/31**

(21) Numéro de dépôt: **26153664.3**

(22) Date de dépôt: **23.01.2026**

(51) Classification Internationale des Brevets (IPC):
**H03K 21/38** (2006.01)   **H03K 23/74** (2006.01)

(52) Classification Coopérative des Brevets (CPC):
**H03K 23/74; H03K 21/38**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **23.01.2025 FR 2500703**

(71) Demandeurs:
• **Commissariat à l'Energie Atomique et aux Energies Alternatives**
**75015 Paris (FR)**
• **Centre National de la Recherche Scientifique**
**75016 Paris (FR)**

• **Université Grenoble Alpes**
**38400 Saint-Martin-d'Hères (FR)**
• **Institut Polytechnique de Grenoble**
**38000 Grenoble (FR)**

(72) Inventeurs:
• **EZZADEEN, Mona**
**38054 Grenoble Cedex 9 (FR)**
• **MINGUET LOPEZ, Joel**
**38054 Grenoble Cedex 9 (FR)**
• **DAMPFHOFFER, Manon**
**38054 Grenoble Cedex 9 (FR)**
• **NAVARRO, Gabriele**
**38054 Grenoble Cedex 9 (FR)**
• **ANTONELLI, Renzo**
**69100 Villeurbanne (FR)**

(74) Mandataire: **Lavoix**
**2, place d'Estienne d'Orves**
**75441 Paris Cedex 09 (FR)**

(54) **MODULE DE COMPTAGE, DISPOSITIF D'ACCUMULATION-COMPARAISON ET CIRCUITS NEUROMORPHIQUES ASSOCIÉS**

(57) La présente invention concerne un module de comptage (12) d'un nombre de détections d'événements dans un intervalle de temps de comptage comportant :
- une unité d'entrée (18) recevant un signal de détection d'un événement dans l'intervalle de temps de comptage,
- un composant de sélection (20), le composant de sélection (20) comprenant un sélecteur comportant une couche active réalisée en un matériau chalcogénure, le sélecteur (26) commutant entre deux états résistifs et un deuxième état résistif en présence d'une impulsion de commutation,
- une unité d'application (22) appliquant une impulsion de comptage sur le sélecteur (26) pour chaque signal de détection reçu par l'unité d'entrée (18), et
- une unité de réinitialisation (24) de l'intervalle de temps de comptage par application d'une impulsion de réinitialisation sur le sélecteur (26).

FIG.1

EP 4 783 463 A1

**Description**

La présente invention concerne un module de comptage. La présente revendication se rapporte également à des systèmes comprenant le module de comptage, à savoir un dispositif propre à réaliser une opération d'accumulation et une opération de comparaison, un circuit électronique implémentant un neurone et un circuit neuromorphique propre à mettre en œuvre un réseau de neurones à sortie binaire.

Pour de multiples applications, parmi lesquelles le traitement automatique de données, l'aide au diagnostic, l'analyse prédictive, les véhicules autonomes, la bioinformatique ou la surveillance, il est connu d'utiliser des algorithmes d'apprentissage automatique faisant partie de programmes pouvant être exécutés sur des processeurs tels que les CPU ou les GPU. Un CPU est un processeur, le sigle CPU provenant du terme anglais « *Central Processing Unit* » signifiant littéralement unité centrale de traitement tandis qu'un GPU est un processeur graphique, le sigle GPU provenant du terme anglais « *Graphics Processing Unit* » signifiant littéralement unité graphique de traitement.

Parmi les techniques de mise en œuvre d'apprentissage, l'emploi de réseaux de neurones est de plus en plus répandu, ces structures étant considérées comme très prometteuses du fait de leurs performances pour de nombreuses tâches telles que la classification automatique de données, la reconnaissance de motifs, la traduction et la compréhension automatique de langues, le contrôle robotique, la navigation automatique, les systèmes de recommandations, la détection d'anomalies, la détection de fraudes, l'étude de l'ADN ou encore la découverte de nouvelles molécules.

Un réseau de neurones est en général composé d'une succession de couches de neurones dont chacune prend ses entrées sur les sorties de la couche précédente. Plus précisément, chaque couche comprend des neurones prenant leurs entrées sur les sorties des neurones de la couche précédente. Chaque couche est reliée par une pluralité de synapses. Un poids synaptique est associé à chaque synapse. C'est un nombre réel, qui prend des valeurs positives comme négatives. Pour chaque couche, l'entrée d'un neurone est la somme pondérée des sorties des neurones de la couche précédente, la pondération étant faite par les poids synaptiques.

Pour une implémentation dans un CPU ou un GPU, une problématique de goulot d'étranglement de Von Neumann (également appelée « *Von Neumann bottleneck* » selon sa dénomination anglaise) apparaît du fait que l'implémentation d'un réseau de neurones profond (à plus de trois couches et allant jusqu'à plusieurs dizaines) implique d'utiliser à la fois la ou les mémoires et le processeur alors que ces derniers éléments sont séparés spatialement. Il en résulte un engorgement du bus de communication entre la ou les mémoires et le processeur à la fois pendant que le réseau de neurones une fois entraîné est utilisé pour réaliser une tâche, et, à plus forte raison, pendant que le réseau de neurones est entraîné, c'est-à-dire pendant que ses poids synaptiques sont réglés pour résoudre la tâche en question avec un maximum de performance.

Il est donc souhaitable de développer des architectures matérielles dédiées, entremêlant mémoire et calcul, pour réaliser des réseaux de neurones rapides, à faible consommation et capables d'apprendre en temps réel.

Il est connu un réseau de neurones reposant sur des technologies de type optique.

Un autre champ de recherche porte sur la réalisation de neurones et de synaspes de réseaux de neurones sur la base d'une technologie de type CMOS. Il est entendu par le sigle « CMOS », oxyde métallique semi-conducteur complémentaire (acronyme provenant de l'expression anglaise « *Complementary Metal-Oxide-Semiconductor* »). Le sigle CMOS désigne aussi bien un procédé de fabrication qu'un composant obtenu par un tel procédé de fabrication.

Toutefois, selon chacune de ces technologies, chaque neurone occupe plusieurs dizaines de micromètres de côté. En outre, chaque synapse occupe également plusieurs dizaines de micromètres de côté. Il en résulte que, sur une surface limitée correspondant par exemple à une puce électronique, le nombre de neurones et de synapses qui peuvent être intégrés est limité, ce qui résulte en une diminution des performances du réseau de neurones.

De ce fait, pour diminuer l'encombrement, il est spécifiquement étudié des architectures dans lesquelles les synapses sont memristives.

Des synapses memristives sont des synapses utilisant des memristors. En électronique, le memristor (ou memristance) est un composant électronique passif. Le nom est un mot-valise formé à partir des deux mots anglais memory et resistor. Un memristor est un composant de mémoire non-volatile, la valeur de sa résistance électrique changeant avec l'application d'une tension ou d'un courant pendant une certaine durée et restant à cette valeur en l'absence de tension, respectivement de courant.

Un exemple d'une telle implémentation est proposé dans un article de L. Wang et al. intitulé « *Efficient and Robust Nonvolatile Computing-In-Memory based on Voltage Division 2T2R RRAM with Input-Dependent Sensing Control* » publié le 19 mars 2021 dans la revue *Transactions on Circuits and Systems II: Express Briefs.*

Dans cette proposition, il est utilisé un pont résistif. Cette approche se base sur le ratio de poids complémentaires. De plus, dans chaque cellule 2T2R (2 transistors - 2 résistances), le courant passe toujours par une somme de résistances en série, au lieu d'une seule résistance. Par conséquent, cette approche permet une réduction non négligeable de la consommation de courant.

Cependant, malgré ces avantages, cette technique est limitée également son utilisation fiable à des neurones à 9 entrées.

Une autre approche est celle d'un article de S. Jung et al. intitulé « A crossbar array of magnetoresistive memory devices for in-memory computing » publié dans Nature 2022 consistant à connecter les poids résistifs en série au lieu de les connecter en parallèle. Les poids sont stockés dans des cellules 2T2R dont les deux transistors sont activés de manière différentielle. L'opération de multiplication entre une entrée et un poids se fait en appliquant l'entrée sur la ligne de mots (WL pour « word line ») de la cellule 2T2R, sélectionnant ainsi un des deux éléments résistifs seulement, dont la valeur est donnée par le poids. Une tension est appliquée à l'une des extrémités de la série de poids, ce qui permet de générer un courant pondéré correspondant à l'opération d'accumulation-comparaison (opération MAC) entre les poids et les entrées. Ce courant charge une capacité en bas de colonne. La tension de la capacité est comparée à une référence dans le temps, permettant ainsi de digitaliser la valeur du MAC sur plusieurs bits grâce à un contrôle digital.

La connexion de tous les poids en série permet de diminuer la consommation de courant comparé aux deux précédentes solutions, cependant, les transistors d'accès étant également connectés en série avec les poids, ils doivent être de grande taille pour ne pas interférer avec le calcul.

De plus, cette technique reste très sensible à la variabilité des cellules résistives (avec une taille de neurone maximale démontrée de 64 entrées), et peut souffrir d'erreurs de délais qui dépendent de la combinaison de poids activé.

Il existe donc un besoin pour un module de comptage permettant de réaliser certaines opérations d'un réseau de neurones binaire qui présente une meilleure intégrabilité dans un ensemble de cellules mémoires.

A cet effet, la description a pour objet un module de comptage d'un nombre de détections d'événements dans un intervalle de temps de comptage, le module de comptage comportant :

- une unité d'entrée propre à recevoir un signal de détection d'un événement dans l'intervalle de temps de comptage,
- un composant de sélection, le composant de sélection comprenant un sélecteur comportant une première électrode, une deuxième électrode et une couche active disposée entre la première électrode et la deuxième électrode, la couche active étant réalisée en un matériau chalcogénure,
le sélecteur étant propre à commuter entre un premier état résistif et un deuxième état résistif en présence d'une impulsion de commutation appliquée entre les deux électrodes, le premier état résistif étant plus résistif que le deuxième état résistif, une impulsion de commutation étant une impulsion présentant une amplitude dépassant une valeur de tension de seuil et appliquant un courant sur le sélecteur supérieur au courant de maintien du sélecteur dans le deuxième état résistif,

- une unité d'application propre à appliquer une impulsion de comptage sur le sélecteur pour chaque signal de détection reçu par l'unité d'entrée,
chaque impulsion de comptage étant une impulsion de commutation présentant une première forme prédéfinie augmentant la valeur de la tension de seuil du sélecteur, la valeur de tension de seuil du sélecteur étant ainsi représentative du nombre de détections d'événements, et
- une unité de réinitialisation de l'intervalle de temps de comptage, l'unité de réinitialisation étant propre à appliquer au moins une impulsion de réinitialisation sur le sélecteur, une impulsion de réinitialisation étant une impulsion de commutation présentant une deuxième forme et diminuant la tension de seuil du sélecteur à une valeur minimale de tension de seuil du sélecteur.

Suivant d'autres aspects avantageux, le module de comptage comprend une ou plusieurs des caractéristiques suivantes, prises isolément ou suivant toutes les combinaisons techniquement possibles :

- chaque impulsion de commutation présente un front montant, un plateau à une valeur maximale et un front descendant, le rapport entre la durée de la somme du plateau et du front descendant pour la deuxième forme prédéfinie et la durée de la somme du plateau et du front descendant pour la première forme prédéfinie étant supérieur ou égal à 2, de préférence supérieur ou égal à 10.
- la durée du plateau d'une impulsion de réinitialisation est supérieure ou égale à 200 ns.
- la durée du front descendant d'une impulsion de réinitialisation est supérieure ou égale à 200 ns.
- la durée du front descendant d'une impulsion de comptage et la durée du plateau d'une impulsion de comptage sont chacune inférieure ou égale à 100 ns.
- l'unité d'entrée comporte une sous-unité de conversion du signal de détection d'un événement reçu en une impulsion de comptage.
- le composant de sélection comporte, en outre, une mémoire résistive, la mémoire résistive présentant au moins deux valeurs de résistance distinctes, la mémoire résistive étant intercalée entre une électrode et la couche active, la valeur de tension de seuil du sélecteur dépendant également de la valeur de résistance de la mémoire résistive.

La description a également pour objet un dispositif propre à réaliser une opération d'accumulation et une opération de comparaison, le dispositif comportant un module de comptage tel que défini précédemment, l'unité d'application étant propre à appliquer des impulsions de comptage présentant une amplitude égale à une valeur de tension de seuil du sélecteur correspondant à un seuil de détection d'événements à atteindre, le dispositif comportant, en outre :

- une unité de comparaison propre à comparer une grandeur représentative de la valeur de la tension de seuil du sélecteur avec une grandeur représentative d'une tension de seuil prédéfinie, la tension de seuil prédéfinie correspondant à un nombre d'impulsions de comptage prédéfini, pour obtenir un résultat de comparaison, et
- une unité de mémorisation du résultat de la comparaison.

Suivant d'autres aspects avantageux, le dispositif comprend une ou plusieurs des caractéristiques suivantes, prises isolément ou suivant toutes les combinaisons techniquement possibles :

- l'unité de comparaison comporte un comparateur en courant, la grandeur représentative de la valeur de la tension de seuil du sélecteur étant le courant de sortie du sélecteur et la grandeur représentative de la tension de seuil prédéfinie étant une valeur de courant.
- l'unité de mémorisation est une bascule.
- l'unité d'application est un transistor.
- l'unité de réinitialisation est un transistor.

La description concerne aussi un circuit électronique implémentant un neurone comprenant un dispositif tel que précédemment décrit..

La description a également pour objet un circuit neuromorphique propre à mettre en œuvre un réseau de neurones à sortie binaire, le circuit neuromorphique comprenant au moins un circuit électronique implémentant un neurone tel que précédemment décrit.

Dans la présente description, l'expression « propre à » signifie indifféremment « adapté pour », « adapté à » ou « configuré pour ».

L'invention apparaîtra plus clairement à la lecture de la description qui va suivre, donnée uniquement à titre d'exemple non limitatif, et faite en référence aux dessins dans lesquels :

- la figure 1 est une représentation schématique d'un dispositif d'accumulation-comparaison, c'est-à-dire un dispositif réalisant une opération d'accumulation et de comparaison,
- la figure 2 est une représentation schématique du fonctionnement d'un dispositif d'accumulation-comparaison,
- la figure 3 est une représentation des couches d'un composant de sélection faisant partie du dispositif d'accumulation-comparaison de la figure 1, le composant de sélection étant un sélecteur à base de matériau chalcogénure,
- la figure 4 comporte des graphes illustrant chacun une courbe caractéristique courant-tension d'un sélecteur OTS présentant deux états résistifs,
- la figure 5 présente des exemples de première forme d'impulsion de commutation conduisant à une augmentation de la valeur de tension de seuil du sélecteur,
- la figure 6 présente un exemple d'évolution de la valeur de la tension de seuil du sélecteur en fonction de nombre d'impulsions de première forme appliquées sur le sélecteur,
- les figures 7 à 10 illustrent schématiquement un fonctionnement du sélecteur de la figure 3 pour réaliser l'opération d'accumulation et de comparaison de la figure 2,
- la figure 11 présente des exemples de deuxième forme d'impulsion de commutation conduisant à une réinitialisation de la valeur de tension de seuil du sélecteur,
- [la figure 12 illustre schématiquement un fonctionnement du sélecteur de la figure 3 pour réaliser une réinitialisation pour l'opération d'accumulation et de comparaison de la figure 2,
- la figure 13 représente deux graphes illustrant respectivement une courbe caractéristique courant-tension d'un composant de sélection formé par un sélecteur à base de matériau chalcogénure en série avec une mémoire à changement de phase pour deux valeurs de la mémoire à changement de phase, le composant de sélection étant schématisé au-dessus des deux graphes,
- la figure 14 est un graphe montrant l'évolution de la tension de commutation en fonction d'un nombre d'impulsions de comptage appliquées au composant de sélection de la figure 13,
- la figure 15 est un graphe permettant de comparer les évolutions de la tension de commutation des figures 5 et 14,
- les figures 16 à 20 illustrent schématiquement un fonctionnement du composant de la figure 1 pour réaliser un neurone d'un réseau de neurones à sortie binaire,
- les figures 21 et 22 sont des représentations schématiques d'un circuit électronique implémentant un neurone et comportant le composant de la figure 1, et
- la figure 23 est un exemple de circuit neuromorphique propre à mettre en œuvre un réseau de neurones à sortie binaire et comportant le composant de la figure 1.

Un dispositif d'accumulation-comparaison 10 est un accumulateur-comparateur qui est propre à réaliser une opération d'accumulation et de comparaison

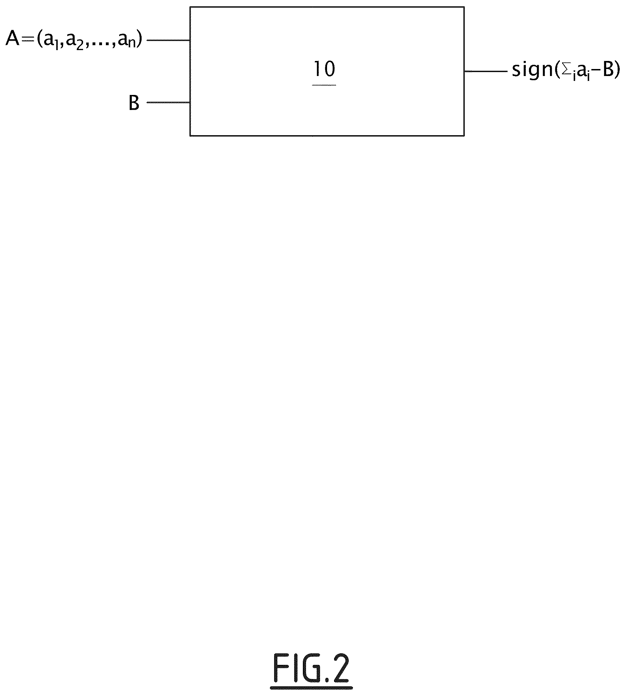

Le fonctionnement du dispositif d'accumulation-comparaison 10 peut ainsi être représenté comme visible sur la figure 2 puisque le dispositif d'accumulation-comparaison 10 cherche à effectuer une opération s'écrivant mathématiquement comme suit :

$$sign\left(\sum_i a_i - B\right)$$

Où:

- $sign(X)$ est la fonction donnant le signe de X,
- $a_i$ désigne les bits valant 1 ou 0,
- $B$ désigne un seuil entier.

Le dispositif d'accumulation-comparaison 10 comporte un module de comptage 12, une unité de comparaison 14 et une unité de mémorisation 16.

Le module de comptage 12 est propre compter un nombre de détection d'événements dans un intervalle de temps de comptage.

Dans l'exemple qui sera décrit, l'événement est une activation d'un neurone.

Toutefois, cela n'est pas limitatif, le module de comptage 12 est, par exemple, utilisable pour dénombrer un nombre de détection d'un objet par une caméra.

Plus généralement, le module de comptage 12 est en liaison avec un détecteur de l'événement, le détecteur de l'événement lui fournissant un signal de détection d'un événement.

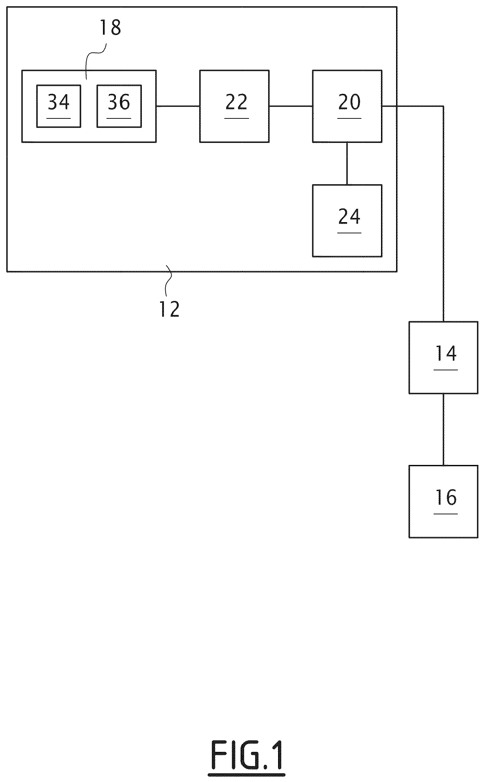

Les différentes unités du module de comptage 12 sont visibles sur la figure 1.

Le module de comptage 12 comporte une unité d'entrée 18, un composant de sélection 20, une unité d'application 22 et une unité de réinitialisation 24.

L'unité d'entrée 18 est propre à recevoir chaque signal de détection d'un événement dans l'intervalle de temps de comptage.

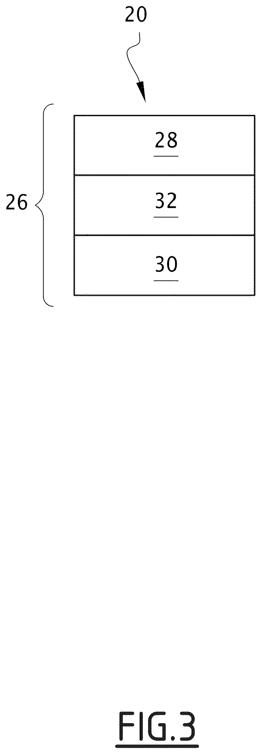

Selon l'exemple de la figure 3, le composant de sélection 20 est un sélecteur 26.

Du fait qu'un seul sélecteur est présent, le composant de sélection 20 est un dispositif dit dispositif 1S.

Un sélecteur a pour fonction de bloquer le passage de courant à faible tension et de permettre le passage d'une forte densité de courant lorsqu'une tension de seuil est atteinte.

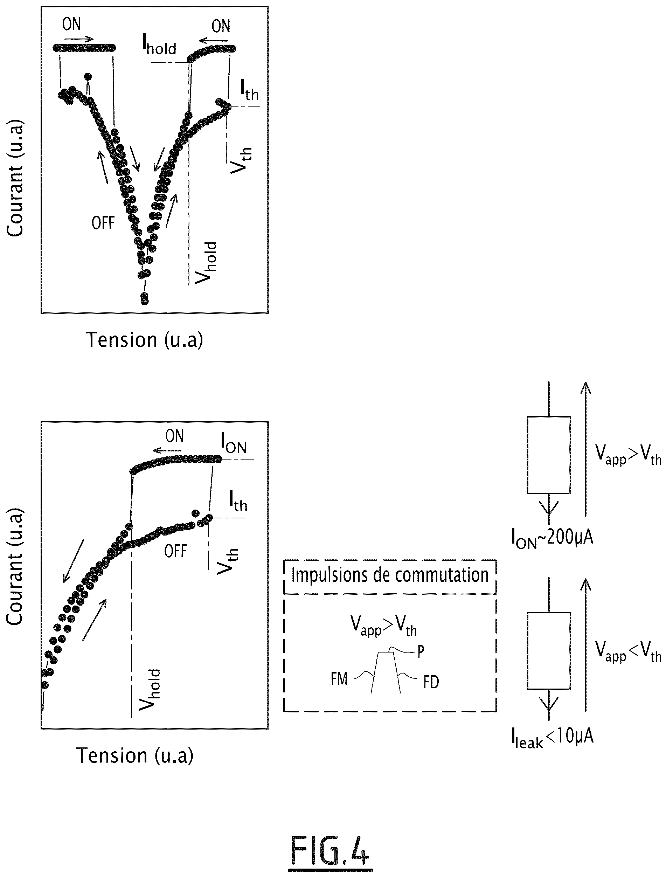

En l'espèce, le sélecteur est un sélecteur de type OTS, c'est-à-dire un sélecteur présentant la courbe caractéristique courant-tension visible sur la figure 4.

Cette courbe montre qu'un sélecteur OTS permet de disposer d'une commutation volatile réversible, symétrique, bipolaire entre un état hautement résistif OFF et un état conducteur ON.

L'abréviation « OTS » renvoie à la dénomination anglaise de « *Ovonic Threshold Switching* » signifiant littéralement « commutation de seuil ovonique ».

Comme visible sur la figure 3, le sélecteur 26 comporte une première électrode 28, une deuxième électrode 30 et une couche active 32.

Les électrodes 28 et 30 sont réalisées chacune dans un matériau conducteur qui peut être différent ou le même pour les deux électrodes 28 et 30.

Le matériau conducteur est, par exemple, choisi parmi du TiN, du TaN, du W, du TiWN, du TiSiN ou du WN.

La couche active 32 est disposée entre la première électrode 28 et la deuxième électrode 30.

La couche active 32 est réalisée en un matériau chalcogénure.

Un chalcogénure est un dianion formé à partir d'un élément chimique de la famille des chalcogènes (typiquement le sélénium et le tellure), qui a gagné deux électrons.

Ici le matériau chalcogénure est un alliage chalcogène, de préférence, le matériau chalcogénure est un alliage comprenant du As, du Sb ou du Ge.

Plus spécifiquement, le matériau chalcogénure est, par exemple du GeSeSbN, du GeSeAsTe ou du SeAsGeSi.

Comme indiqué précédemment, le sélecteur 26 présente le comportement illustré par la courbe caractéristique courant-tension de la figure 4.

L'application d'une impulsion électrique présentant une amplitude supérieure à une tension de seuil (ou tension de commutation) notée $V_{th}$ entre les deux électrodes 28 et 30 du sélecteur 26 entraîne une commutation du sélecteur entre un premier état résistif (état OFF) et un deuxième état résistif (état ON).

L'amplitude est ici définie comme la différence de potentiel entre les deux électrodes 28 et 30 du sélecteur 26.

Par ailleurs, l'impulsion électrique doit également appliquer un courant sur le sélecteur 26 supérieur au courant de maintien du sélecteur 26 dans le deuxième état résistif pour assurer une commutation stable.

Le courant de maintien est visible sur la figure 4 et est noté $I_{hold}$.

Une telle impulsion électrique est notée impulsion de commutation dans la suite, cette impulsion de commutation permettant de commuter entre l'état OFF et l'état ON.

Comme visible sur la figure 4, l'écart de résistance entre l'état OFF et l'état ON est très important, l'état OFF correspondant à une très forte résistance, typiquement une valeur 10 fois supérieure, de préférence une valeur 100 fois supérieure.

Une telle commutation réalisée par une impulsion de commutation est souvent désignée sous l'appellation commutation « OFF-ON » en référence à la dénomination anglaise correspondante et la tension de seuil.

Ainsi, lorsqu'une impulsion de commutation est appliquée, le sélecteur 26 est dans l'état ON et un courant noté $I_{ON}$ traverse le composant de sélection 20.

Le courant $I_{ON}$ est limité par la présence d'un transistor d'accès. Le courant $I_{ON}$ est parfois dénommé courant de compliance et est bien supérieur au courant de maintien $I_{hold}$ du sélecteur 26.

A contrario, lorsqu'est appliquée une impulsion électrique d'amplitude inférieure à la tension de seuil notée $V_{th}$ et/ou correspondant à un courant strictement inférieur au courant de maintien $I_{hold}$ du sélecteur 26, le sélecteur 26 reste dans l'état OFF et un courant noté $I_{leak}$ traverse le dispositif 10, le courant $I_{leak}$ étant bien inférieure au courant $I_{ON}$.

Comme visible sur la figure 4, chaque impulsion de commutation présente un front montant FM, un plateau P et un front descendant FD.

Parmi ces impulsions de commutations, certaines présentent une forme spécifique dite première forme prédéfinie et ont pour effet d'augmenter la valeur de tension de seuil du sélecteur 26.

Dans la suite, ces impulsions de commutations sont dénommées impulsions de première forme.

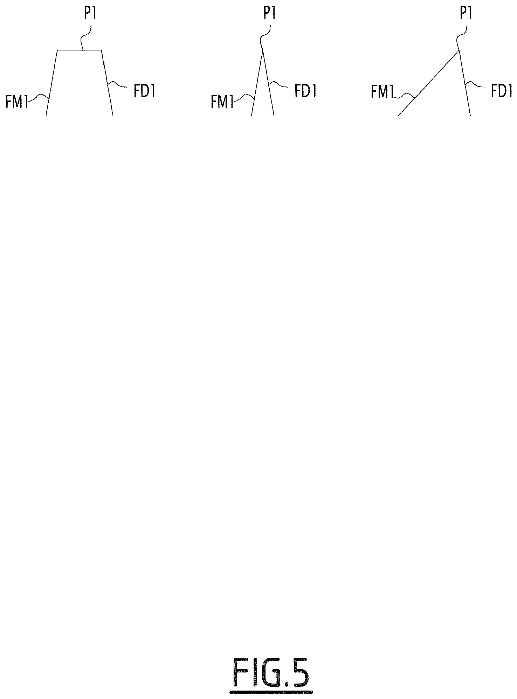

Des exemples d'impulsions de première forme sont schématisés sur la figure 5.

Chacune des impulsions de première forme ont en commun de présenter un front descendant FD1 et un plateau P1 relativement courts.

La durée du front descendant FD1 d'une impulsion de première forme est inférieure ou égale à 100 nanosecondes (ns), de préférence inférieure ou égale à 50 ns.

La durée du plateau P1 d'une impulsion de première forme est inférieure ou égale à 100 ns.

Comme cela apparaît sur la figure 5 et notamment les exemples du centre et de droite, le plateau P1 peut être fortement réduit jusqu'à une valeur nulle.

Par ailleurs, la comparaison entre les exemples du centre et de droite montre également que la durée du front montant FM1 n'est pas ici critique pour les impulsions de première forme.

En présence de telles impulsions de première forme, la tension de seuil du sélecteur 26 augmente en fonction du nombre d'impulsions appliquées entre les deux électrodes 28 et 30.

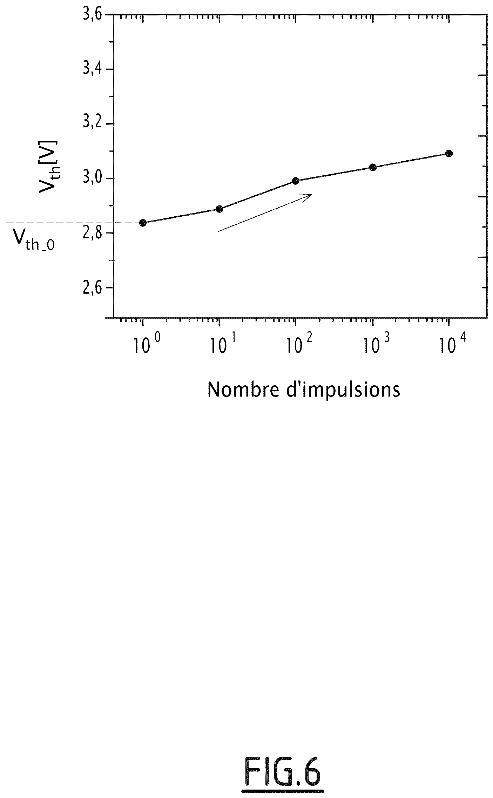

Cette augmentation de la tension de seuil en fonction du nombre d'impulsions de commutation est représentée sur la figure 6 pour un courant de compliance de 100 $\mu$A.

Dans cet exemple de la figure 6, les impulsions de première forme présentent la même polarité. On entend par polarité ici le fait qu'une impulsion prend uniquement des valeurs de tension de même signe.

Il est observé qu'à partir d'une tension de seuil initiale notée $V_{th\_0}$ de l'ordre de 2,85 V, la valeur de la tension de seuil augmente avec le nombre d'impulsions de première forme pour atteindre une valeur de 3,1 V pour 10000 impulsions de première forme.

De ce fait, les impulsions de première forme sont des impulsions de comptage au sens où elles permettent une augmentation de la valeur de tension de seuil du sélecteur 26 qui dépend du nombre d'impulsions de comptage appliquées.

Le rôle de l'unité d'application 22 du module de comptage 12 est d'appliquer ces impulsions de comptage pour chaque signal de détection reçu par l'unité d'entrée 18.

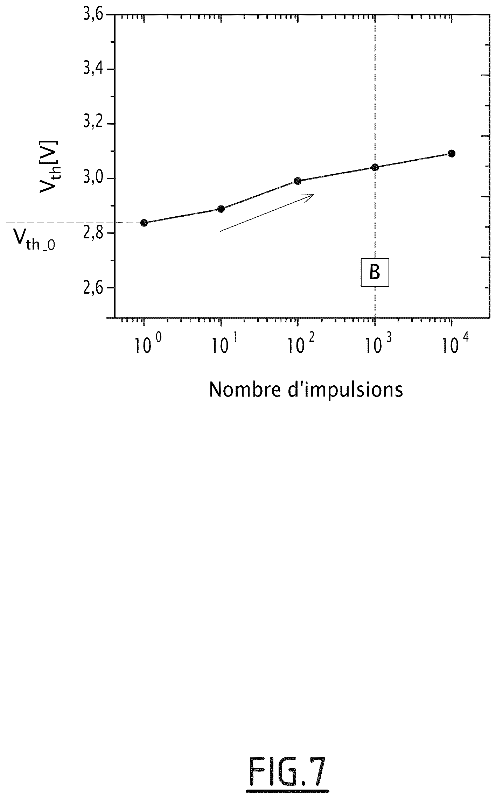

En référence aux figures 7 à 11, il est possible d'exploiter cette variation de la tension de seuil pour réaliser une fonction d'accumulation.

Pour cela, il est supposé que l'évolution de la tension de seuil du sélecteur 26 en fonction du nombre d'impulsions de comptage est connue.

Un nombre d'impulsions de comptage à accumuler est choisi. Ce nombre est un seuil d'accumulation noté B dans la suite.

Ce seuil d'accumulation B sera choisi en fonction de l'application souhaitée pour le dispositif d'accumulation-comparaison 10.

Le seuil d'accumulation B est égal à 1000 impulsions de comptage dans l'exemple de la figure 7 et est représenté schématiquement par une ligne verticale en pointillés.

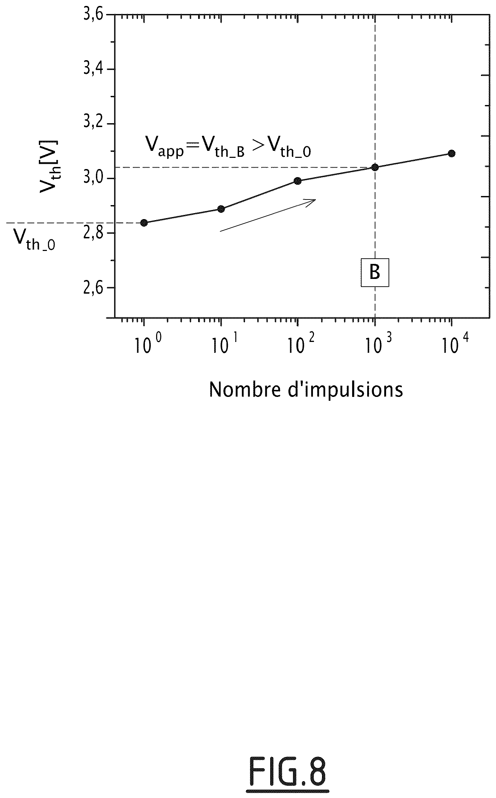

Comme représenté sur la figure 8, à partir de ce seuil d'accumulation B, il est obtenu une valeur finale de tension de seuil, c'est-à-dire la valeur maximale atteinte par la tension de seuil du sélecteur 26 pendant l'accumulation. Cette valeur de tension est notée $V_{th\_B}$

En l'espèce, pour un seuil d'accumulation B de 1000, la valeur finale de tension de seuil $V_{th\_B}$ est égale à 3,05 V.

La valeur finale de tension de seuil définit dans ce cas l'amplitude des impulsions de comptage à appliquer entre les deux électrodes 28 et 30.

Plus précisément, une impulsion de comptage présente une amplitude de $V_{th\_B}$ en plus des conditions précitées, à savoir que la forme de l'impulsion de comptage est selon la première forme et que le courant appliquée par l'impulsion de comptage est supérieur ou égal au courant de maintien $I_{hold}$.

Cela conduit à un fonctionnement selon deux configurations pour le composant de sélection 20 selon la valeur de seuil atteint par le sélecteur 26.

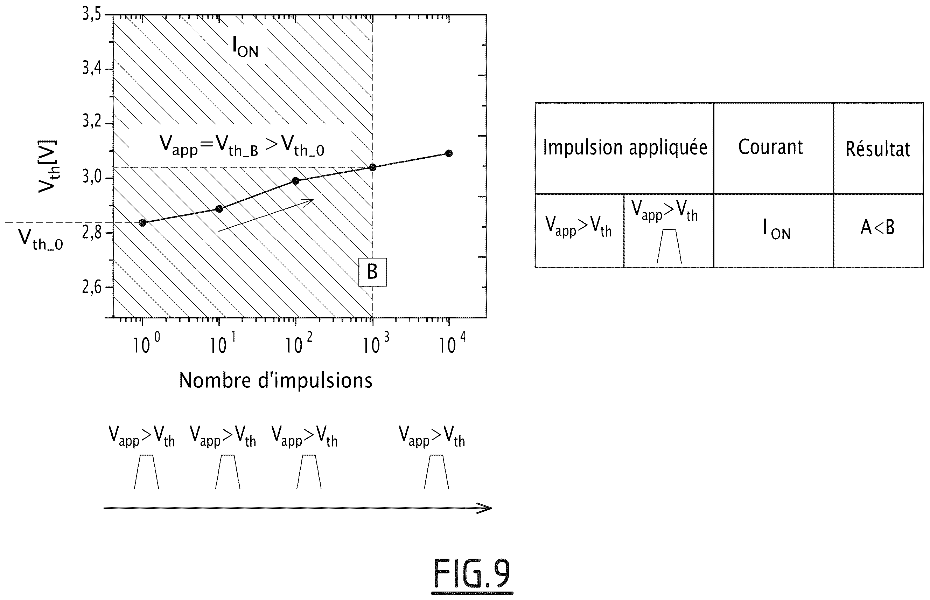

Dans une première configuration correspondant au cas de la figure 9, chaque impulsion de comptage induit une augmentation de la valeur de la tension de seuil $V_{th}$ parce que la valeur de l'amplitude de l'impulsion de comptage est supérieure à la valeur de la tension de seuil $V_{th}$. Cela correspond au fait que le nombre d'impulsions de comptage est strictement inférieur au seuil d'accumulation B.

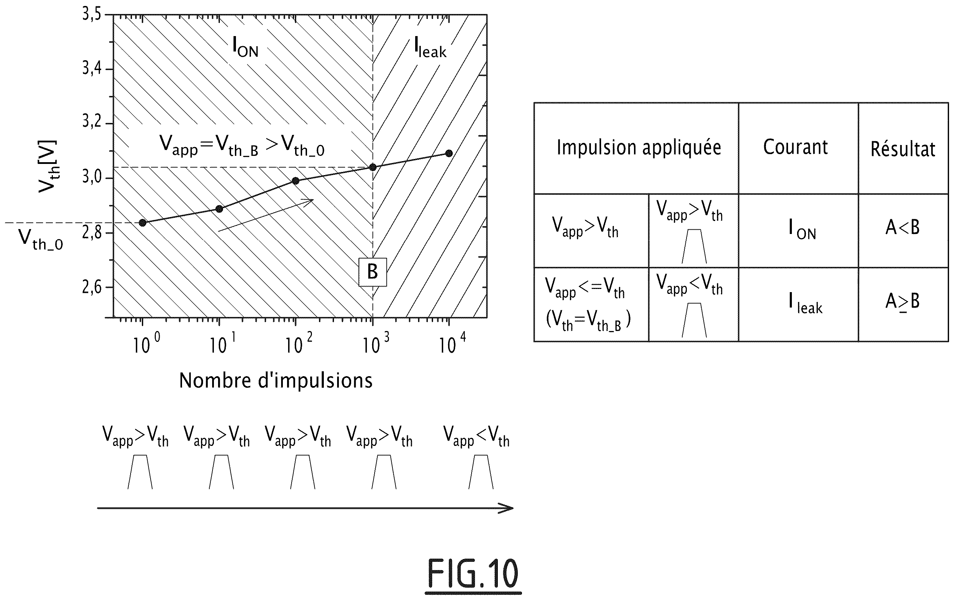

Dans une deuxième configuration correspondant au cas de la figure 10, la valeur de la tension appliquée est toujours de $V_{th\_B}$ mais la tension de seuil atteinte par le sélecteur 26 est aussi égale à $V_{th\_B}$, de sorte que la tension appliquée par l'unité d'application 22 ne respecte pas la condition de commutation selon laquelle la tension appliquée est supérieure ou égale à la tension de seuil du sélecteur 26. Dans ce cas, il n'est plus possible de générer une commutation du sélecteur 26 et le courant reste inférieur ou égal à $I_{leak}$.

Il est ainsi bien réalisé une fonction d'accumulation jusqu'au seuil d'accumulation B pendant un intervalle de temps, dit intervalle de temps de comptage.

L'unité de réinitialisation 24 permet de réaliser une réinitialisation de l'intervalle de temps de comptage, ce qui permet d'utiliser le module de comptage 12 plusieurs fois.

Pour cela, l'unité de réinitialisation 24 est propre à appliquer des impulsions d'une deuxième forme prédéfinie entre les deux électrodes 28 et 30.

Les impulsions de deuxième forme sont des impulsions de commutation, et à ce titre appliquent sur le sélecteur 26 un courant de compliance plus fort que le courant de maintien $I_{hold}$ et que le courant appliqué par les impulsions de comptage.

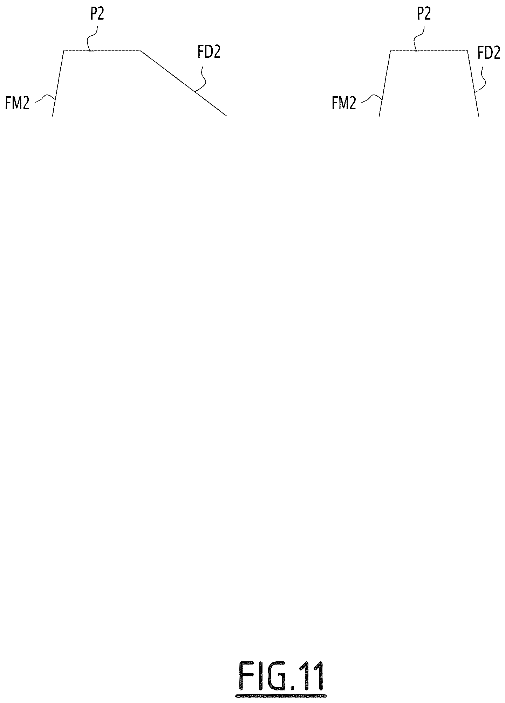

Deux exemples d'impulsions de deuxième forme sont représentés sur la figure 11.

Chacune des impulsions de deuxième forme ont en commun de présenter un plateau P2 relativement long.

Typiquement, la durée du plateau P2 d'une impulsion de deuxième forme est supérieure ou égale à 200 ns, de préférence supérieure ou égale à 700 ns.

Avantageusement, comme c'est le cas pour l'exemple de gauche de la figure 11, la durée du front descendant FD2 est également relativement longue, par exemple supérieure ou égale à 200 ns, de préférence supérieure ou égale à 500 ns.

Plus généralement, la deuxième forme peut être déterminée à partir de la première forme en imposant que le rapport entre la durée de la somme du plateau P2 et du front descendant FD2 pour la deuxième forme prédéfinie et la durée de la somme du plateau P1 et du front descendant FD1 pour la première forme prédéfinie soit supérieur ou égal à 2.

Ce rapport est, de préférence, supérieur ou égal à 5, avantageusement supérieur ou égal à 10.

Dans la mesure où les fronts descendants FD1 et FD2 peuvent être très courts, le rapport précédent est, dans certains modes de réalisation, égal au rapport entre les plateaux P2 et P1.

Par ailleurs, la comparaison entre les exemples de la figure 11 montre également que la durée du front montant FM2 n'est pas ici critique pour les impulsions de deuxième forme.

En présence de telles impulsions de deuxième forme, la tension de seuil du sélecteur 26 diminue jusqu'à la valeur minimale de tension de seuil du sélecteur 26 (c'est-à-dire un nombre d'impulsions de comptage nul).

Ces impulsions de deuxième forme constituent donc des impulsions de réinitialisation.

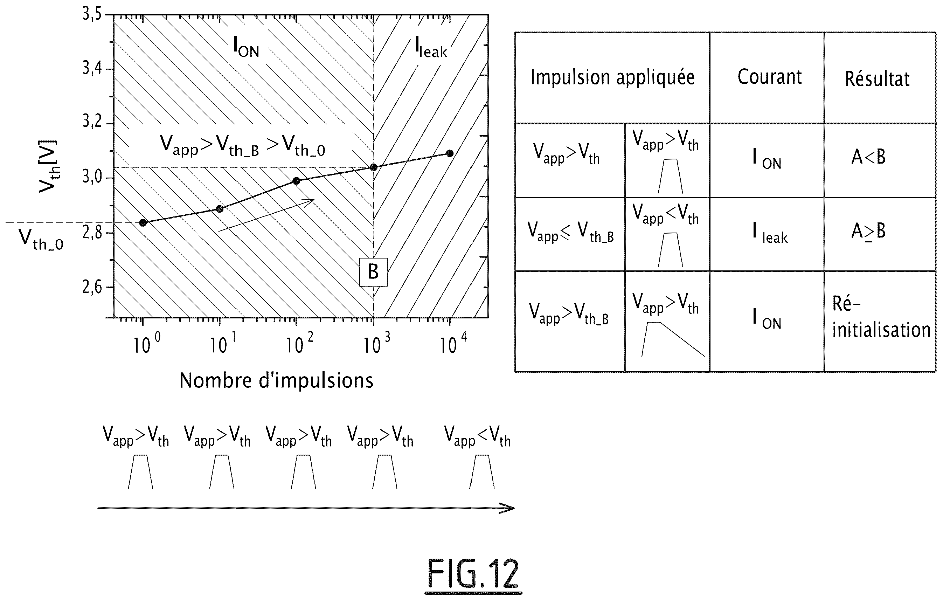

Dans l'exemple décrit, cela correspond à appliquer une impulsion telle que visible sur le tableau de la figure 12, cette impulsion de réinitialisation ayant pour effet de faire commuter le sélecteur 26 et de faire revenir la valeur de tension de seuil du sélecteur 14 revient à sa valeur initiale $V_{th\_0}$.

Le dispositif d'accumulation-comparaison 10 est alors revenu à sa première configuration et peut à nouveau être utilisé comme accumulateur-comparateur avec le même seuil d'accumulation B ou un nouveau seuil d'accumulation si cela est souhaité en changeant simplement la valeur de la tension appliquée par chaque impulsion de comptage.

Un moyen pour réaliser simplement un changement du seuil d'accumulation B est de disposer à l'unité d'entrée 18 d'une sous-unité de réception 34 et d'une sous-unité de conversion 36.

La sous-unité de conversion 36 sert à convertir le signal de détection d'un événement d'un événement reçu par la sous-unité de réception 34 en une impulsion de comptage.

Il suffit de modifier la valeur maximale des impulsions de sortie de la sous-unité de conversion 36 pour modifier le seuil d'accumulation B.

Le composant 10 permet ainsi d'exploiter le comportement du composant de sélection 20 pour réaliser une opération d'accumulation.

Le composant 10 présente l'avantage de la simplicité dans la mesure où cette opération est réalisée au niveau du sélecteur 26.

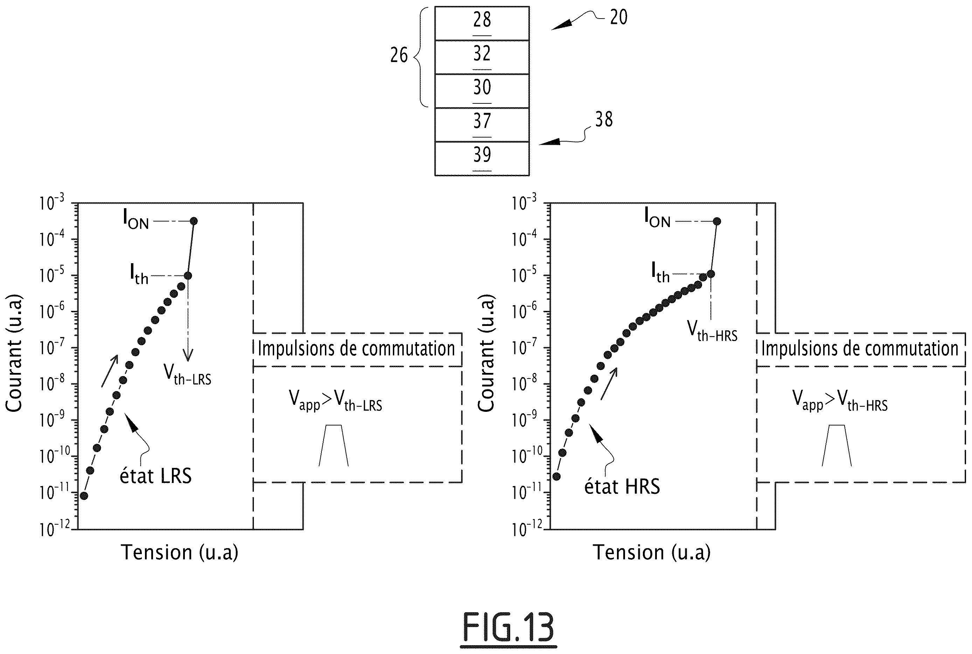

Un autre mode de réalisation du composant de sélection 20 est représenté sur la figure 13.

Selon l'exemple de la figure 13, le composant de sélection 20 comporte un sélecteur 26 et une mémoire résistive 38 en série avec le sélecteur 26.

Plus précisément, la mémoire résistive 38 est formé dans la composant de sélection 20 qui est formé par cinq couches, à savoir la première électrode 28 (qui est l'électrode inférieure du composant de sélection 20), la couche active 32 (celle du sélecteur 26), la deuxième électrode 30 (qui est l'électrode intermédiaire séparant le sélecteur 26 et la mémoire résistive 38), une deuxième couche active 37 (qui est la couche active correspondant à la mémoire résistive) et une troisième électrode 39 (servant d'électrode supérieure du composant de sélection).

Dans ce cas, la mémoire résistive 38 peut présenter deux états, un état haut et un état bas. Bien entendu, le nombre d'états de la mémoire résistive 38 peut être choisi plus grand si cela est souhaitable pour l'application envisagée

L'état haut correspond à une forte résistance et est généralement désigné par l'abréviation HRS renvoyant au terme anglais de « *High Resistive* State » qui signifie littéralement état fortement résistif. L'état haut est, de ce fait, dénommé état haut HRS dans la suite.

L'état bas correspond à une faible résistance et est généralement désigné par l'abréviation LRS renvoyant au terme anglais de « *Low Resistive State* » qui signifie littéralement état faiblement résistif. L'état bas est, de ce fait, dénommé état bas LRS dans la suite.

La mémoire résistive 38 est, par exemple, une mémoire à changement de phase (mémoire PCM) ou une mémoire ReRAM.

Dans ce cas, le composant de sélection 20 est un dispositif en configuration 1S1R (c'est-à-dire une configuration 1 sélecteur avec 1 élément résistif).

La partie centrale et la partie de droite de la figure 13 illustrent la caractéristique courant-tension du composant de sélection 20 respectivement pour une mémoire résistive 38 programmée à l'état LRS et à l'état HRS.

Dans chacun des cas, pour le cas d'impulsion de commutation dont la tension est positive, une impulsion de commutation présentant une amplitude supérieure au seuil considéré permet d'obtenir une commutation. Cette impulsion de commutation implique aussi que le composant de sélection 20 voit un courant supérieur au courant de maintien du sélecteur 26 mais inférieur au courant de reprogrammation de la mémoire résistive 38.

Dans le cas d'une mémoire résistive 38 programmée à l'état LRS, la valeur de tension de seuil est $V_{th-LRS}$ alors que, dans le cas d'une mémoire résistive 38 programmée à l'état HRS, la valeur de tension de seuil est $V_{th-HRS}$ qui est supérieure à la valeur de tension de seuil dans l'état LRS de $V_{th-LRS}$.

Lorsque la mémoire résistive 38 est programmée à l'état HRS, la tension appliquée doit être plus grande que Vth'=Vth-HRS pour faire commuter le sélecteur 26. Lorsque la mémoire résistive 38 est programmée à l'état LRS, la tension appliquée doit être plus grande que Vth'=Vth-LRS pour faire commuter le sélecteur 26.

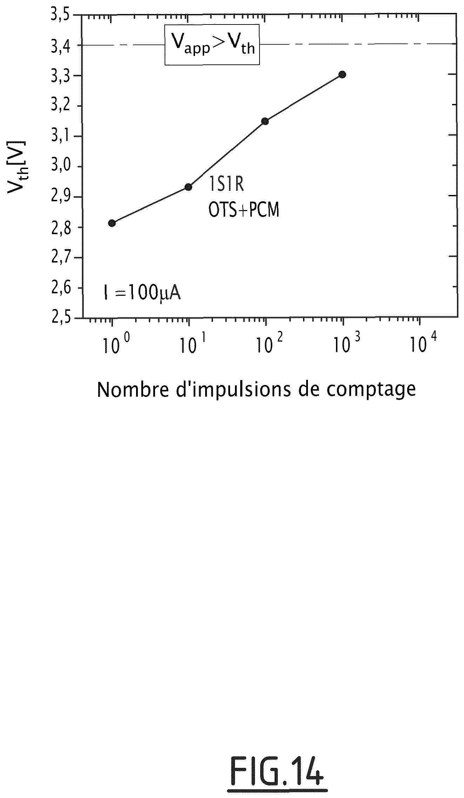

La figure 14 montre que l'application successive d'impulsions de comptage à une amplitude strictement supérieure à $V_{th'}$ conduit au même effet d'augmentation de la valeur de la tension de seuil.

Pour l'exemple de la figure 14, il a été considéré une mémoire résistive 38 programmée à l'état LRS avec un courant de compliance de 100 μA pour éviter la reprogrammation de la mémoire résistive 38 au cours des commutations successives du sélecteur 26.

Le phénomène physique observé étant le même que précédemment, le composant de sélection 20 selon le mode de réalisation de la figure 13 peut également être utilisée comme accumulateur-comparateur.

Pour bien comprendre l'intérêt d'un tel mode de réalisation en configuration 1S1R par rapport à une configuration 1S, la variation de la valeur de la tension de seuil en fonction du nombre d'impulsions de comptage appliquées observée sur la figure 14 est à comparer à celle de la figure 5.

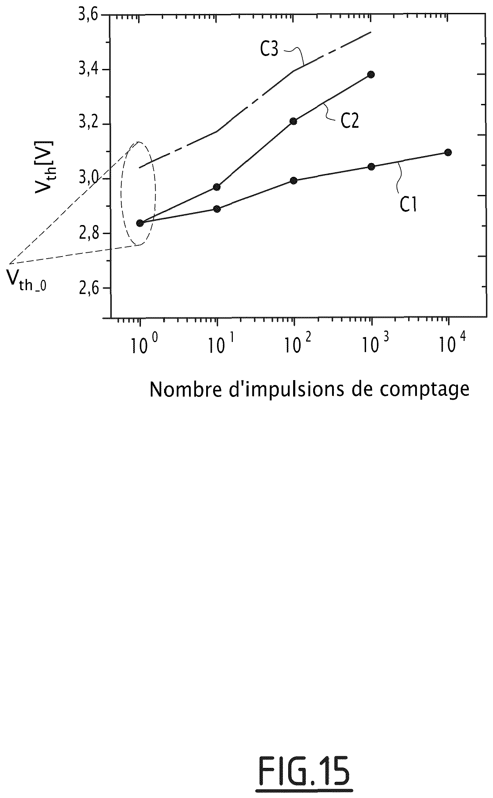

Pour cela, il a été reporté avec la même échelle, sur la figure 15, la variation pour un sélecteur 26 seul (courbe C1), la variation pour un sélecteur 26 avec une mémoire résistive 38 dans l'état LRS (courbe C2) et la variation pour un sélecteur 26 avec une mémoire résistive 38 dans l'état HRS (courbe C3).

La comparaison des courbes C2 et C3 correspondant à l'état LRS et à l'état HRS montre que la tension de seuil initiale $V_{th\_0}$ n'est pas la même dans les états.

Plus précisément, plus la mémoire résistive 38 sera programmée avec une forte résistivité, plus la tension de seuil initiale $V_{th\_0}$ deviendra grande.

Le composant de sélection 20 permet donc à travers le choix de la valeur de la résistance de la mémoire résistive 38 de contrôler également la valeur de la tension de seuil initiale $V_{th\_0}$.

Dans chacun des cas, un tel dispositif d'accumulation-comparaison 10 peut être utilisé dans une réalisation physique d'un neurone d'un réseau de neurones binaire.

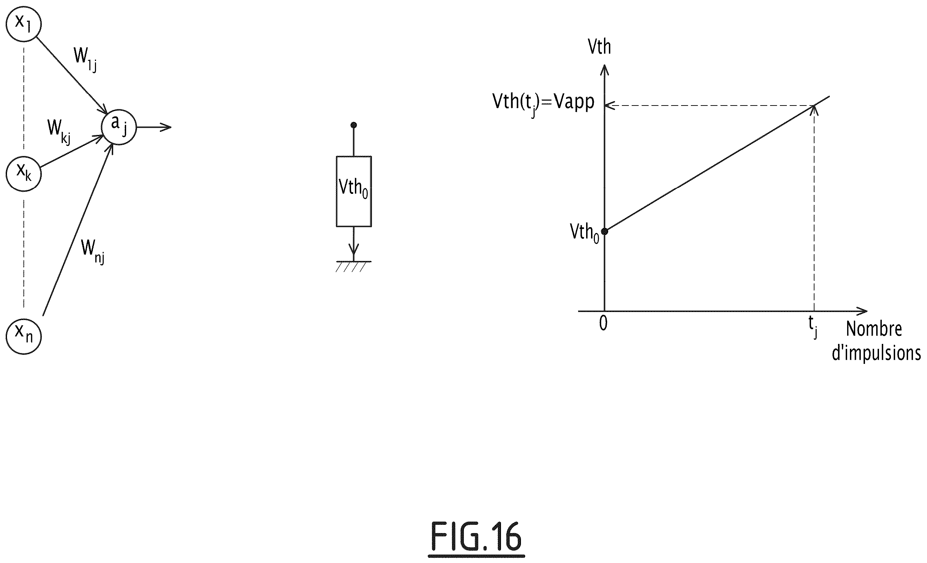

Une telle utilisation est illustrée en référence aux figures 16 à 20.

La structure d'un neurone binaire est illustrée schématiquement sur la partie gauche de la figure 16.

Un neurone binaire donné possède $n$ entrées $x_i$, qui sont multipliées par leurs poids synaptiques correspondants $w_i$. Dans cette notation, l'indice $i$ est un entier variant entre 1 et $n$.

Les entrées et les poids sont binaires et ne peuvent valoir que deux valeurs, qui sont ici égales à 0 et 1.

Plus précisément, un réseau de neurones binaire se caractérise par des poids et activations de valeurs 1 et -1. Mais les activations et poids négatifs (-1) sont échangés par des « 0 » afin de l'assimiler à une opération XNOR

Aussi, la multiplication entre une entrée et un poids synaptique revient à effectuer une simple opération XNOR.

Les résultats des multiplications entre les entrées et les poids sont alors sommés (opération de popcount), et comparés à un seuil $t_j$. Si la somme est supérieure au seuil, la sortie du neurone sera égale à 1, sinon, elle sera égale à 0.

Autrement formulé, la sortie du neurone s'écrit mathématiquement comme suit :

$$a_j = sign\left(POPCOUNT_i\left(XNOR(w_{i,j}, x_i) - t_j\right)\right)$$

La partie droite de la figure 16 montre l'état initial du neurone. Le dispositif a alors été initialisé à sa tension de seuil initiale $V_{th\_0}$.

Il est choisi comme tension $V_{app}$ pour les impulsions de comptage une valeur égale à $V_{th}(t_j)$, c'est-à-dire lorsque la valeur de $V_{th}$ lorsque le nombre d'impulsions de comptage appliquées au sélecteur 26 est égal au seuil $t_j$.

Il s'agit ensuite d'accumuler les $XNOR(w_{i,j}, x_i)$ successifs.

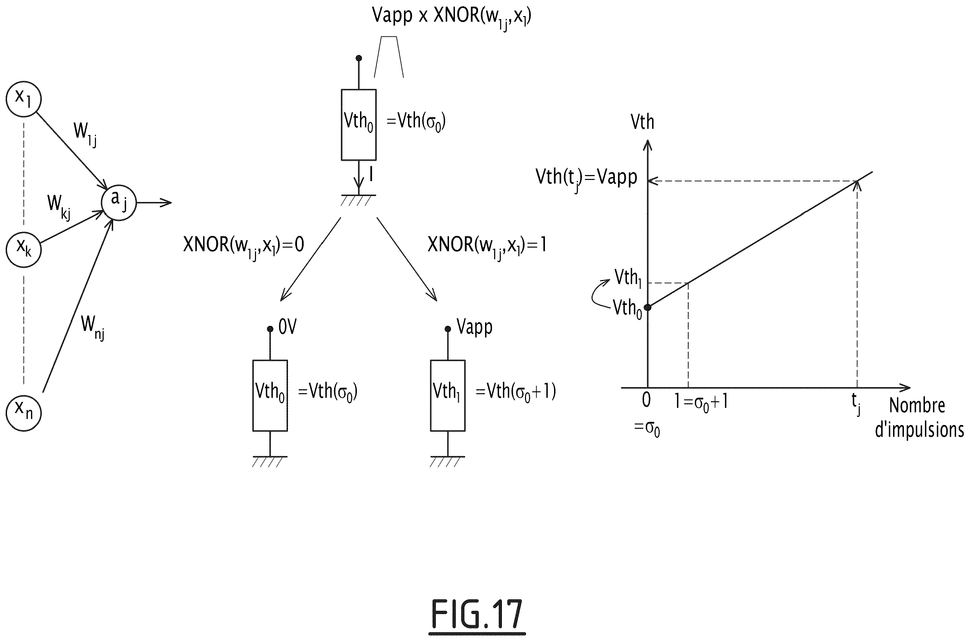

La figure 17 illustre alors ce qui se passe à la première accumulation du neurone.

Comme illustré sur cette figure, une impulsion de commutation d'amplitude $V_{app} * XNOR(w_{1,j}, x_1)$ est appliquée sur le sélecteur 26

Pour la suite, il est défini $\sigma_k$ comme suit :

$$\sigma_k = \sum_{i=1}^{k} XNOR(w_{i,j}, x_i)$$

Ce terme $\sigma_k$ peut être interprété comme un popcount partiel (pour lequel i n'a été accumulé que jusqu'à k).

Selon un premier cas, $XNOR(w_{1,j}, x_1) = 0$.

Dans ce cas, l'amplitude de l'impulsion de comptage est nulle. Il en résulte que la tension de seuil du sélecteur 26 vaut :

$$V_{th}(\sigma_1) = V_{th}(\sigma_0) = V_{th\_0}$$

Selon un deuxième cas, $XNOR(w_{1,j}, x_1) = 1$.

Dans ce cas, le popcount partiel est incrémenté de 1 et l'amplitude de l'impulsion de comptage vaut $V_{app}$, ce qui a pour effet d'augmenter la tension de seuil du sélecteur 26 à une valeur $V_{th}(\sigma_1) > V_{th}(\sigma_0)$.

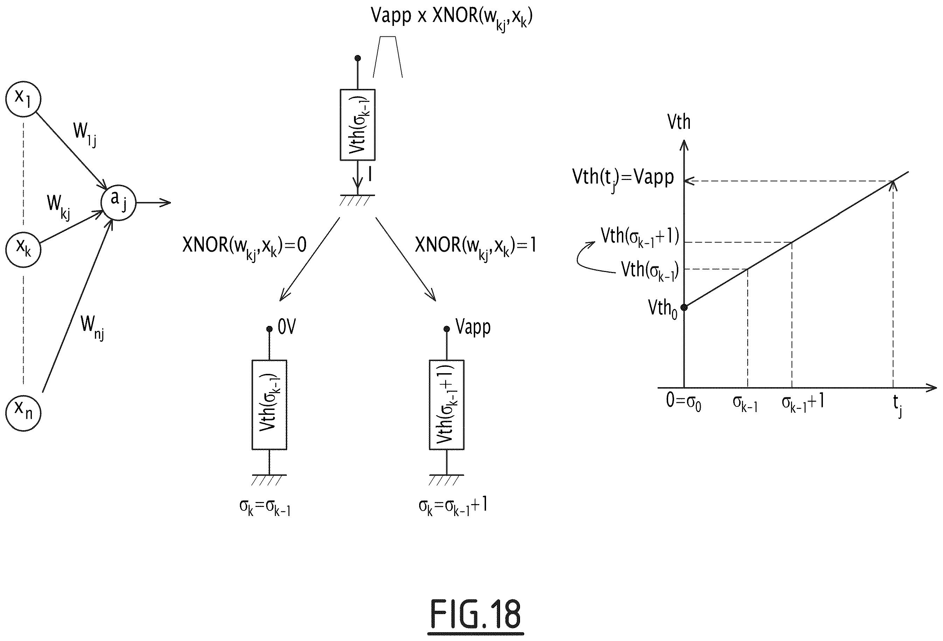

La figure 18 illustre ce qui se passe pour la k-ième accumulation.

Une impulsion de comptage d'amplitude $V_{app} * XNOR(w_{k,j}, x_k)$ est appliquée sur le sélecteur 26.

Selon un premier cas, $XNOR(w_{k,j}, k) = 0$.

Dans ce cas, l'amplitude de l'impulsion de comptage est nulle. Il en résulte que la tension de seuil du sélecteur 26 vaut :

$$V_{th}(\sigma_k) = V_{th}(\sigma_{k-1})$$

Selon un deuxième cas, $XNOR(w_{k,j}, x_k) = 1$.

Dans ce cas, le popcount partiel est incrémenté de 1 et l'amplitude de l'impulsion de comptage vaut $V_{app}$, ce qui a pour effet d'augmenter la tension de seuil du sélecteur 26 à une valeur $V_{th}(\sigma_k) > V_{th}(\sigma_{k-1})$.

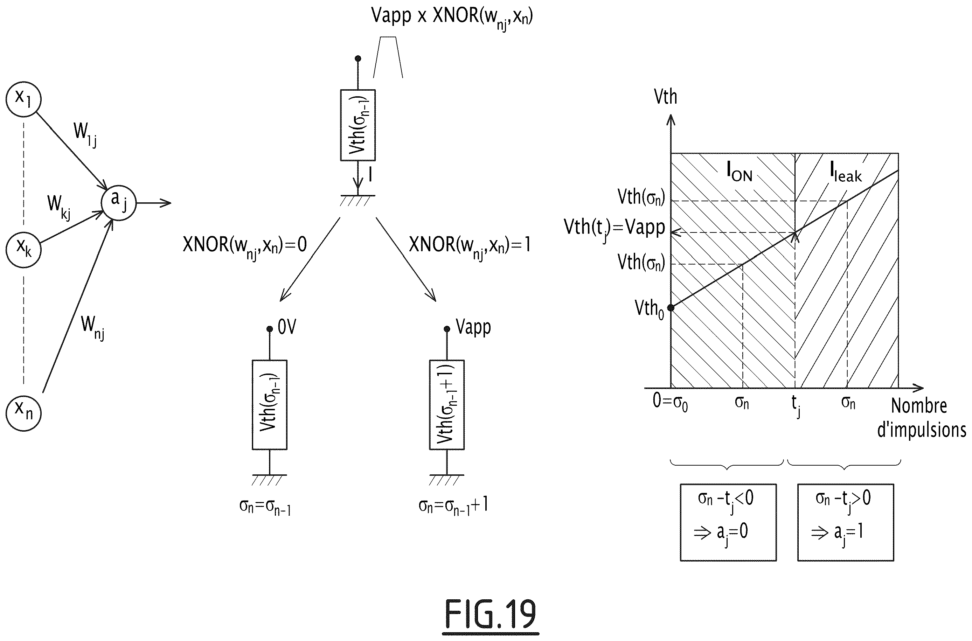

La figure 19 illustre schématiquement la mise en œuvre de la dernière itération qui se déroule similairement.

Comme précédemment, deux cas sont possibles.

Selon un premier cas, $\sigma_n < t_j$.

Dans ce cas, la dernière impulsion présentant une impulsion non nulle, à savoir la m-ième impulsion de comptage, a effectivement ouvert le sélecteur 26 et généré un courant $I_{ON}$, car la valeur de la tension de seuil du sélecteur 26 est supérieure à la valeur du popcount.

Dans cette notation, m est la valeur de l'indice k qui correspond au dernier $XNOR(w_{k,j}, x_k) = 1$.

Il peut d'ailleurs être noté que la relation suivante est vérifiée :

$$POPCOUNT_i\left(XNOR(w_{i,j}, x_i)\right) = \sum_{i=1}^{m} XNOR(w_{i,j}, x_i) = \sigma_m$$

L'amplitude de la m-ième impulsion de comptage $V_{app}$ * $XNOR(w_{m,j}, x_m)$ a généré une telle ouverture car :

$$V_{th}(\sigma_n) = V_{th}(\sigma_m) < V_{th}(t_j) = V_{app}$$

Cette relation est vérifiée car $\sigma_m = \sigma_n < t_j$.

Ce cas correspond à une sortie de neurone à 0.

Selon un deuxième cas, $\sigma_n > t_j$.

Dans ce cas, l'amplitude de la m-ième impulsion de comptage $V_{app}$ * $XNOR(w_{m,j}, x_m)$ n'a pas généré l'ouverture du sélecteur 26 et résultant en une observation du courant $I_{th}$, car le seuil du sélecteur 26 est inférieur au popcount.

Ce cas correspond à une sortie de neurone à 1.

Selon un mode de réalisation, il est avantageux d'arrêter le comptage dès qu'une impulsion de comptage ne génère pas l'ouverture du sélecteur 26, ce qui permettrait d'éviter de réaliser l'accumulation au-delà d'une impulsion qui a déjà permis de dépasser le seuil et donc d'obtenir une sortie de neurone à 1.

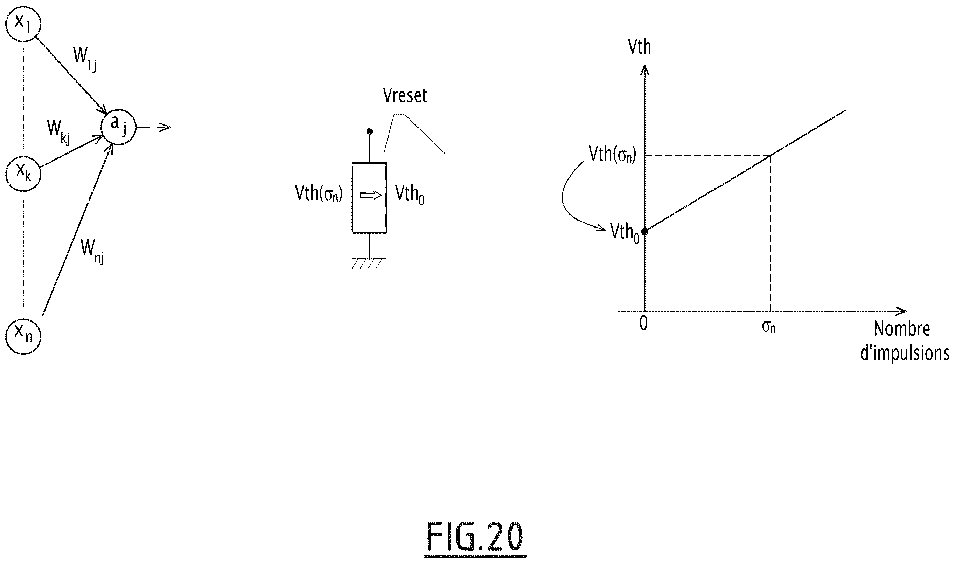

Comme illustré très schématiquement sur la figure 20, il est mis en oeuvre après cette accumulation, une opération de réinitialisation de la valeur de la tension de seuil par application d'une impulsion de réinitialisation.

Ce fonctionnement peut être exploité dans un circuit électronique 39 implémentant un neurone tel que celui de la demande européenne EP 4 137 999 publié le 22 février 2023 et dont le contenu est inséré ici par référence.

Pour rappel, ce circuit électronique 39 illustre le cas particulier d'un neurone binaire à base de mémoire résistive pour calculer les opérations XNOR entre le poids et les entrées : les poids du neurone sont stockés de manière différentielle dans des structures 2T2R, les entrées $x_i$ sont appliquées de manière séquentielle sur la ligne de bit et son complément, et la ligne de source est reliée à un inverseur.

Au sein d'une même colonne la i-ième ligne mémorise le poids d'indice i. Ainsi, il suffit d'activer séquentiellement les lignes de mots $WL_i$ les unes après les autres pour pouvoir générer les $XNOR(w_{k,j}, x_k)$ successifs.

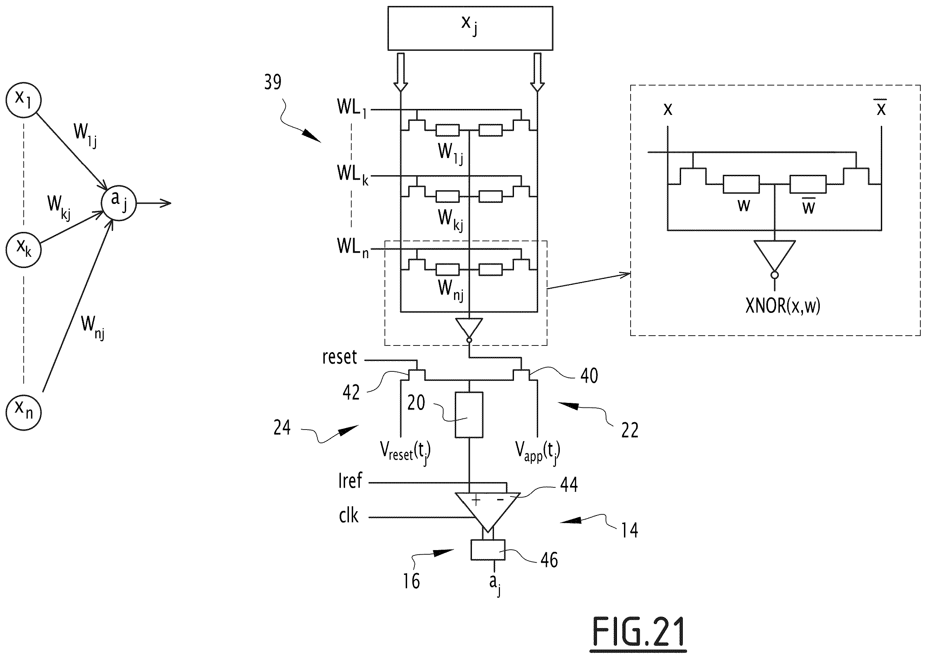

De manière très schématique comme visible sur la figure 21, le dispositif d'accumulation-comparaison 10 se situe en bas de colonne. Le dispositif d'accumulation-comparaison 10 comporte le composant de sélection 20 qui est connecté à l'unité de comparaison 14.

L'unité d'application 22 est un premier transistor 40 piloté par la sortie de l'inverseur (et donc par les $XNOR(w_{k,j}, x_k)$) successifs), permettant d'appliquer les impulsions de comptage.

L'unité de réinitialisation 24 est ici également un deuxième transistor 42 permettant d'appliquer l'impulsion de réinitialisation sur le composant de sélection 20,

L'unité de comparaison 14 comprend un comparateur 44 permettant de comparer le courant $I_{read}$ par rapport à un courant de référence $I_{ref}=(I_{ON}+I_{th})/2$.

A la sortie du comparateur 44, une unité de mémorisation 16 permet de forcer un « 1 » en sa sortie dès que le seuil du neurone a été dépassé.

L'unité de mémorisation 16 est ici une bascule 46.

En fonctionnement, on suppose que le sélecteur 26 a subi une réinitialisation de sorte que la tension de seuil est à la valeur initiale $V_{th\_0}$ (en utilisant le deuxième transistor 42)

Ensuite, on vient activer la première ligne de mot $WL_1$ ce qui donne une première valeur $XNOR(w_{1,j}, x_1)$. Dans le cas où cette valeur vaut 1, le premier transistor 40 applique une impulsion de commutation.

La valeur de sortie du sélecteur 26 est comparée par le comparateur 44 au courant de référence et le résultat est mémorisé dans la bascule 46.

De même, on vient activer la deuxième ligne de mot $WL_2$ ce qui donne une deuxième valeur $XNOR(w_{1,j}, x_1)$. Dans le cas où cette valeur vaut 1, le deuxième transistor 42 applique une impulsion de commutation.

La valeur de sortie du sélecteur 26 est comparée par le comparateur 44 au courant de référence et le résultat est mémorisé dans la bascule.

Et ainsi de suite pour chacune des lignes de mots.

Il suffira alors de lire la valeur de la bascule 46 pour déterminer si la sortie du neurone vaut 0 ou 1.

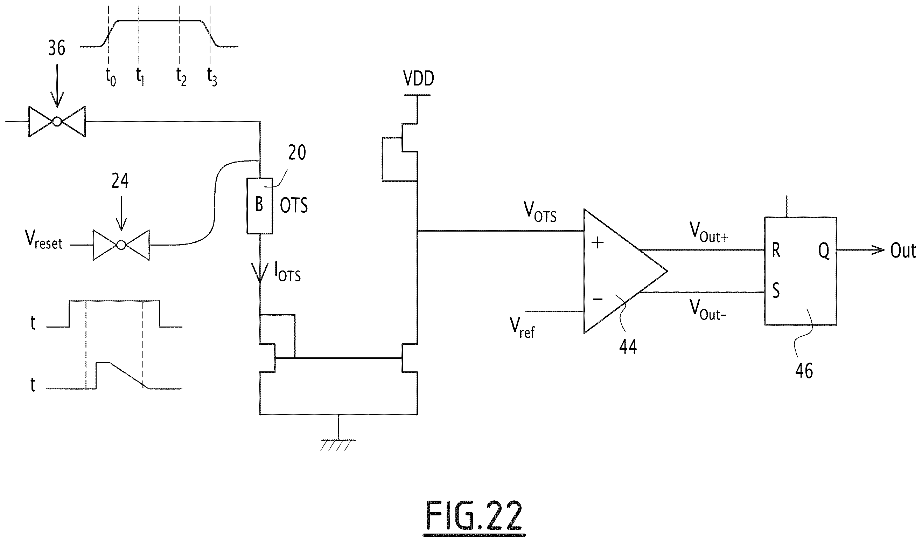

Une exemple pratique d'implémentation des fonctions qui viennent d'être décrite pour le circuit électronique est représenté sur la figure 22.

Dans ce cas, le sélecteur 26 est relié à un miroir de courant permettant de copier la valeur du courant de sortie du sélecteur 20 pour obtenir une tension $V_{OTS}$ à comparer à une référence $V_{Ref}$.

La référence sera choisie comme correspondant à la valeur médiane des valeurs extrêmes que peut prendre le sélecteur 26, soit parce que cette valeur est connue soit par utilisation d'un montage à miroir de courant avec un autre sélecteur qui serait dans l'état OFF lorsqu'on veut générer la référence.

Dans ce circuit électronique 39, le seuil d'impulsions B pourra être contrôlé de plusieurs manières.

Il a déjà été présenté le choix de l'amplitude des impulsions de comptage grâce à la sous-unité de conversion 36, qui est ici un interrupteur commandable.

Le choix de la valeur de résistance de la mémoire résistive 38 est une autre manière de faire varier la valeur du seuil d'impulsions B.

Une autre idée est d'ajouter artificiellement des impulsions additionnelles (par exemple en utilisant des colonnes additionnelles de RRAM), ce qui fera diminuer la valeur de B d'une valeur dépendant du nombre de ces impulsions additionnelles.

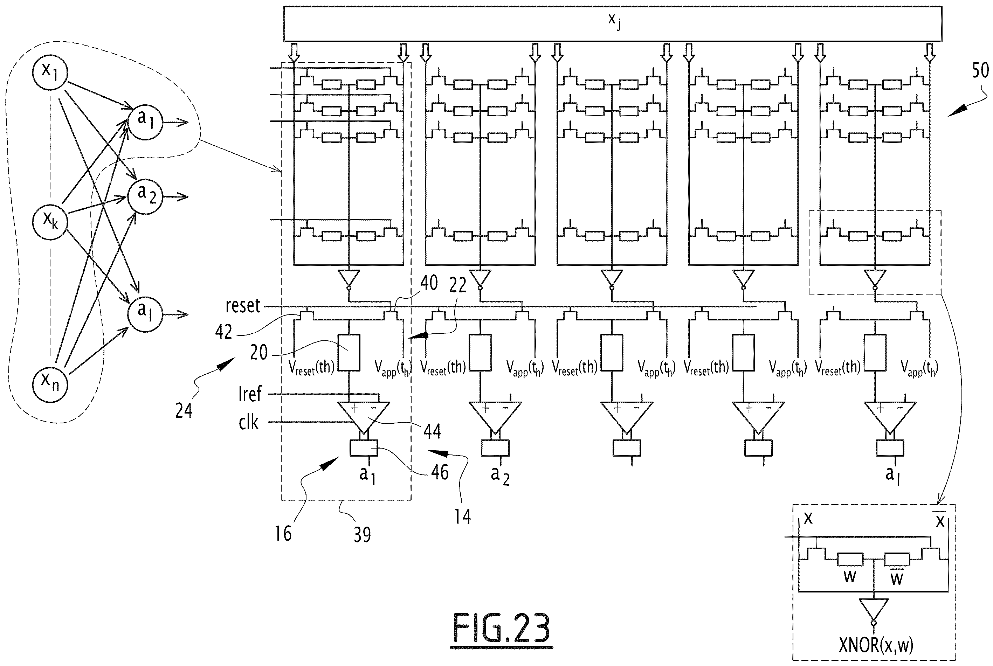

Ce circuit électronique 39 est destiné à faire partie d'un circuit neuromorphique 50 propre à mettre en œuvre un réseau de neurones à sortie binaire comme cela est schématisé sur la figure 23.

Il est ainsi obtenu un circuit neuromorphique 50 capable d'implémenter un réseau de neurones binaire avec une meilleure intégrabilité dans un ensemble de cellules mémoires.

Ce circuit neuromorphique 50 exploite ainsi avantageusement un module de comptage 12 qui est capable de compter un nombre de détections d'événements dans un intervalle de temps de comptage.

Le module de comptage 12 comporte l'unité d'entrée 18, le composant de sélection 20, l'unité d'application 22 et l'unité de réinitialisation 24.

Le nombre d'événements à détecter est alors accessible avec la valeur de la tension de seuil du sélecteur 26.

Dans les cas d'applications où il est souhaité connaître le nombre d'événements à détecter, le module de comptage 12 peut également comporte une unité de mesure additionnelle propre à déterminer la valeur de la tension de seuil du sélecteur 26.

**Revendications**

**1.** Module de comptage (12) d'un nombre de détections d'événements dans un intervalle de temps de comptage, le module de comptage (12) comportant :

- une unité d'entrée (18) propre à recevoir un signal de détection d'un événement dans l'intervalle de temps de comptage,
- un composant de sélection (20), le composant de sélection (20) comprenant un sélecteur (26) comportant une première électrode (28), une deuxième électrode (30) et une couche active (32) disposée entre la première électrode (28) et la deuxième électrode (30), la couche active (32) étant réalisée en un matériau chalcogénure, le sélecteur (26) étant propre à commuter entre un premier état résistif et un deuxième état résistif en présence d'une impulsion de commutation appliquée entre les deux électrodes (28, 30), le premier état résistif étant plus résistif que le deuxième état résistif, une impulsion de commutation étant une impulsion présentant une amplitude dépassant une valeur de tension de seuil et appliquant un courant sur le sélecteur (26) supérieur au courant de maintien du sélecteur dans le deuxième état résistif,
- une unité d'application (22) propre à appliquer une impulsion de comptage sur le sélecteur (26) pour chaque signal de détection reçu par l'unité d'entrée (18),
chaque impulsion de comptage étant une impulsion de commutation présentant une première forme prédéfinie augmentant la valeur de la tension de seuil du sélecteur (26), la valeur de tension de seuil du sélecteur (26) étant ainsi représentative du nombre de détections d'événements, et
- une unité de réinitialisation (24) de l'intervalle de temps de comptage, l'unité de réinitialisation (24) étant propre à appliquer au moins une impulsion de réinitialisation sur le sélecteur (26), une impulsion de réinitialisation étant une impulsion de commutation présentant une deuxième forme et diminuant la tension de seuil du sélecteur à une valeur minimale de tension de seuil du sélecteur (26).

**2.** Module de comptage selon la revendication 1, dans lequel chaque impulsion de commutation présente un front montant (FM), un plateau (P) à une valeur maximale et un front descendant (FD), le rapport entre la durée de la somme du plateau (P2) et du front descendant (FD2) pour la deuxième forme prédéfinie et la durée de la somme du plateau (P1) et du front descendant (FD1) pour la première forme prédéfinie étant supérieur ou égal à 2, de préférence supérieur ou égal à 10.

**3.** Module de comptage selon la revendication 2, dans lequel la durée du plateau (P2) d'une impulsion de réinitialisation est supérieure ou égale à 200 ns.

**4.** Module de comptage selon la revendication 2 ou 3, dans lequel la durée du front descendant (FD2) d'une impulsion de réinitialisation est supérieure ou égale à 200 ns.

**5.** Module de comptage selon l'une quelconque des revendications 2 à 4, dans lequel la durée du front descendant (FD1) d'une impulsion de comptage et la durée du plateau (P1) d'une impulsion de comptage sont chacune inférieure ou égale à 100 ns.

**6.** Module de comptage selon l'une quelconque des revendications 1 à 5, dans lequel l'unité d'entrée (18) comporte une sous-unité de conversion (36) du signal de détection d'un événement reçu en une impulsion de comptage.

**7.** Module de comptage selon l'une quelconque des revendications 1 à 6, dans lequel le composant de sélection (20) comporte, en outre, une mémoire résistive (38), la mémoire résistive (38) présentant au moins deux valeurs de résistance distinctes, la mémoire résistive (38) étant intercalée entre une électrode (28, 30) et la couche active (32), la valeur de tension de seuil du sélecteur (26) dépendant également de la valeur de résistance de la mémoire résistive (38).

**8.** Dispositif (10) propre à réaliser une opération d'accumulation et une opération de comparaison, le dispositif (10) comportant un module de comptage (12) selon l'une quelconque des revendications 1 à 7, l'unité d'application (22) étant propre à appliquer des impulsions de comptage présentant une amplitude égale à une valeur de tension de seuil du sélecteur (26) correspondant à un seuil de détection d'événements à atteindre, le dispositif (10) comportant, en outre :

- une unité de comparaison (14) propre à comparer une grandeur représentative de la valeur de la tension de seuil du sélecteur (26) avec une grandeur représentative d'une tension de seuil prédéfinie, la tension de seuil prédéfinie correspondant à un nombre d'impulsions de comptage prédéfini, pour obtenir un résultat de comparaison, et
- une unité de mémorisation (16) du résultat de la comparaison.

**9.** Dispositif selon la revendication 8, dans lequel l'unité de comparaison (14) comporte un comparateur (44) en courant, la grandeur représentative de la valeur de la tension de seuil du sélecteur (26) étant le courant de sortie du sélecteur (26) et la grandeur représentative de la tension de seuil prédéfinie étant une valeur de courant.

**10.** Dispositif selon la revendication 8 ou 9, dans lequel l'unité de mémorisation (16) est une bascule (46).

**11.** Dispositif selon l'une quelconque des revendications 8 à 10, dans lequel l'unité d'application (22) est un transistor (40).

**12.** Dispositif selon l'une quelconque des revendications 8 à 11, dans lequel l'unité de réinitialisation (24) est un transistor (42).

**13.** Circuit électronique (39) implémentant un neurone comprenant un dispositif (10) selon l'une quelconque des revendications 8 à 12.

**14.** Circuit neuromorphique (50) propre à mettre en œuvre un réseau de neurones à sortie binaire, le circuit neuromorphique (50) comprenant au moins un circuit électronique (39) implémentant un neurone selon la revendication 13.

18

34 36

22

20

24

12

14

16

FIG.1

$$A=(a_1,a_2,\ldots,a_n) \longrightarrow \boxed{\underline{10}} \longrightarrow \text{sign}(\Sigma_i a_i - B)$$

$$B \longrightarrow$$

## FIG.2

20

26 {
| 28 |
| 32 |
| 30 |

FIG.3

FIG.4

P1

FM1     FD1

P1

FM1     FD1

P1

FM1     FD1

# FIG.5

FIG.6

FIG.7

$$V_{app} = V_{th\_B} > V_{th\_0}$$

$V_{th}[V]$

$V_{th\_0}$

B

$10^0 \quad 10^1 \quad 10^2 \quad 10^3 \quad 10^4$

Nombre d'impulsions

FIG.8

FIG.9

$V_{app}=V_{th\_B}>V_{th\_0}$

$I_{ON}$  $I_{leak}$

$V_{th\_0}$

$V_{th}[V]$

B

Nombre d'impulsions

| Impulsion appliquée | | Courant | Résultat |
|---|---|---|---|
| $V_{app}>V_{th}$ | $V_{app}>V_{th}$ | $I_{ON}$ | $A<B$ |
| $V_{app}<=V_{th}$ ($V_{th}=V_{th\_B}$) | $V_{app}<V_{th}$ | $I_{leak}$ | $A\geq B$ |

$V_{app}>V_{th}$  $V_{app}>V_{th}$  $V_{app}>V_{th}$  $V_{app}>V_{th}$  $V_{app}<V_{th}$

FIG.10

EP 4 783 463 A1

P2

FD2

FM2

P2

FD2

FM2

FIG.11

EP 4 783 463 A1

Graph axes: $V_{th}[V]$ (vertical), "Nombre d'impulsions" (horizontal)

$I_{ON}$     $I_{leak}$

$V_{app} > V_{th\_B} > V_{th\_0}$

$V_{th\_0}$     B

| Impulsion appliquée | | Courant | Résultat |
|---|---|---|---|
| $V_{app} > V_{th}$ | $V_{app} > V_{th}$ | $I_{ON}$ | A<B |
| $V_{app} \leqslant V_{th\_B}$ | $V_{app} < V_{th}$ | $I_{leak}$ | A≥B |
| $V_{app} > V_{th\_B}$ | $V_{app} > V_{th}$ | $I_{ON}$ | Ré-initialisation |

$V_{app} > V_{th}$  $V_{app} > V_{th}$  $V_{app} > V_{th}$  $V_{app} > V_{th}$  $V_{app} < V_{th}$

FIG.12

FIG.13

FIG.14

FIG.15

EP 4 783 463 A1

$$Vth(t_j)=Vapp$$

$$Vth_0$$

FIG.16

FIG.17

FIG.18

EP 4 783 463 A1

$$Vapp \times XNOR(w_{nj}, x_n)$$

$Vth(\sigma_{n-1})$

$I$

$XNOR(w_{nj}, x_n) = 0$     $XNOR(w_{nj}, x_n) = 1$

$0V$     $Vapp$

$Vth(\sigma_{n-1})$     $Vth(\sigma_{n-1}+1)$

$\sigma_n = \sigma_{n-1}$     $\sigma_n = \sigma_{n-1}+1$

$W_{1j}$

$W_{kj}$

$W_{nj}$

$x_1$     $a_j$

$x_k$

$x_n$

$Vth$

$I_{ON}$     $I_{leak}$

$Vth(\sigma_n)$

$Vth(t_j) = Vapp$

$Vth(\sigma_n)$

$Vth_0$

$0 = \sigma_0$     $\sigma_n$     $t_j$     $\sigma_n$     Nombre d'impulsions

$\sigma_n - t_j < 0$     $\sigma_n - t_j > 0$
$\Rightarrow a_j = 0$     $\Rightarrow a_j = 1$

FIG.19

**FIG.20**

FIG.21

EP 4 783 463 A1

FIG.22

FIG.23

XNOR(x,w)

**EP 4 783 463 A1**

| | Europäisches Patentamt<br>European Patent Office<br>Office européen des brevets | **RAPPORT DE RECHERCHE EUROPEENNE** | **Numéro de la demande**<br>**EP 26 15 3664** |

## DOCUMENTS CONSIDERES COMME PERTINENTS

| Catégorie | Citation du document avec indication, en cas de besoin,<br>des parties pertinentes | Revendication<br>concernée | CLASSEMENT DE LA<br>DEMANDE (IPC) |
|---|---|---|---|
| A | RENZO ANTONELLI ET AL: "Programming Operations Analysis and Statistics in One Selector and One Memory Ovonic Threshold Switching + Phase-Change Memory Double-Patterned Self-Aligned Structure", PHYSICA STATUS SOLIDI. RAPID RESEARCH LETTERS, WILEY - V C H VERLAG, DE, vol. 18, no. 10, 17 février 2024 (2024-02-17), page n/a, XP072711657, ISSN: 1862-6254, DOI: 10.1002/PSSR.202300429<br>* Partie 2;<br>figure 1 *<br>* Partie 3.2 *<br>* Partie 3.3;<br>figure 7 * | 1-14 | INV.<br>H03K21/38<br>H03K23/74 |
| A | BAN SANGHYUN ET AL: "Pulse Dependent Threshold Voltage Variation of the Ovonic Threshold Switch in Cross-Point Memory", IEEE ELECTRON DEVICE LETTERS, IEEE, USA, vol. 41, no. 3, 28 janvier 2020 (2020-01-28), pages 373-376, XP011774251, ISSN: 0741-3106, DOI: 10.1109/LED.2020.2969962 [extrait le 2020-02-25]<br>* abrégé *<br>* Partie III.;<br>figures 1,2 * | 1-14 | **DOMAINES TECHNIQUES RECHERCHES (IPC)**<br><br>H03K |

-/--

Le présent rapport a été établi pour toutes les revendications

| Lieu de la recherche | Date d'achèvement de la recherche | Examinateur |
|---|---|---|
| Munich | 3 juin 2026 | Martínez Martínez, J |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
& : membre de la même famille, document correspondant

EPO FORM 1503 03.82 (P04C02)

page 1 de 2

| Europäisches Patentamt European Patent Office Office européen des brevets | **RAPPORT DE RECHERCHE EUROPEENNE** | Numéro de la demande EP 26 15 3664 |
|---|---|---|

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | CHAI ZHENG ET AL: "Dependence of Switching Probability on Operation Conditions in GexSe1-x Ovonic Threshold Switching Selectors", IEEE ELECTRON DEVICE LETTERS, IEEE, USA, vol. 40, no. 8, 1 août 2019 (2019-08-01), pages 1269-1272, XP011736243, ISSN: 0741-3106, DOI: 10.1109/LED.2019.2924270 [extrait le 2019-07-23] * abrégé * * Partie III.; figure 5 * ----- | 1-14 | |

| | DOMAINES TECHNIQUES RECHERCHES (IPC) |
|---|---|

Le présent rapport a été établi pour toutes les revendications

| Lieu de la recherche | Date d'achèvement de la recherche | Examinateur |
|---|---|---|
| Munich | 3 juin 2026 | Martínez Martínez, J |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
....................
& : membre de la même famille, document correspondant

EPO FORM 1503 03.82 (P04C02)

page 2 de 2

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 4137999 A

**Littérature non-brevet citée dans la description**

- **S. JUNG et al.** A crossbar array of magnetoresistive memory devices for in-memory computing. *Nature*, 2022